# EUROPEAN PATENT APPLICATION

(11) **EP 4 415 486 A1**
(43) Date of publication of application: **14.08.2024**
(21) Application number: 23168106.5
(22) Date of filing: 14.04.2023
(51) Int. Cl.: H05K 1/02, H01L 23/498, H01L 23/00, H05K 1/18, H05K 3/34

(54) **CONNECTION COMPONENTS FOR CONNECTING A SEMICONDUCTOR PACKAGE WITH A BOTTOM STIFFENER TO A PRINTED CIRCUIT BOARD**

(30) Priority: 07.02.2023 US 202318165790
(71) Applicant: Juniper Networks, Inc., Sunnyvale, CA 94089 (US)
(72) Inventor: GANGULY, Gautam, Sunnyvale, 94089 (US); KUGEL, Valery, Sunnyvale, 94089 (US); AHMED, Omar, Sunnyvale, 94089 (US); HUTCHINSON, Leif, Sunnyvale, 94089 (US); SU, Peng, Sunnyvale, 94089 (US); TWAROG, Matthew, Sunnyvale, 94089 (US); ARANYOSI, Attila I., Sunnyvale, 94089 (US); OWEN, David K., Sunnyvale, 94089 (US); WU, Chang-Hong, Sunnyvale, 94089 (US); HASSANZADEH, Aliaskar, Sunnyvale, 94089 (US); REYNOV, Boris, Sunnyvale, 94089 (US); SAGARWALA, Muhammad, Sunnyvale, 94089 (US)
(74) Representative: D Young & Co LLP

(57) **Abstract**

An apparatus (202), includes a PCB (204), a semiconductor package (102) that includes a substrate (104) and a stiffener (108) with an opening, and at least one connection component (206). The stiffener (108) is disposed on a top surface of the PCB (204). The at least one connection component (206) is configured to connect the PCB (204) to the semiconductor package (102). The at least one connection component (206) may include another PCB (206) that is disposed on the substrate (104) within the opening of the stiffener (108) and on the PCB (204). The at least one connection component may include an array of connectors that are disposed on the substrate within the opening of the stiffener, and may include a socket disposed on the PCB. The at least one connection component may include a BGA that is disposed on the substrate within the opening of the stiffener and on the PCB and on a pedestal portion of a surface of the PCB.

## Description

### BACKGROUND

A semiconductor package includes one or more semiconductor devices, such as one or more integrated circuits. Semiconductor device components may be fabricated on semiconductor wafers, diced into dies, and then packaged. A semiconductor package may include elements, such as balls, pins, or leads, for connecting components of the semiconductor package to an external component (e.g., a circuit board).

### SUMMARY

Particular aspects are set out in the appended independent claims. Various optional embodiments are set out in the dependent claims.

In some implementations, an apparatus includes a printed circuit board (PCB); a semiconductor package disposed on a top surface of the PCB that includes a substrate and a stiffener, wherein a top surface of the stiffener is disposed on a bottom surface of the substrate, and wherein a bottom surface of the stiffener is disposed on a top surface of the PCB; and at least one connection component that is configured to connect the PCB and the semiconductor package.

In some implementations, an apparatus includes a substrate; a stiffener with an opening disposed on a bottom surface of the substrate; a PCB disposed on a bottom surface of the stiffener; and at least one connection component that is configured to connect the PCB to at least one of the stiffener or the substrate.

In some implementations, an apparatus includes a PCB; a semiconductor package that includes a substrate and a stiffener, wherein the stiffener is disposed on a top surface of the PCB; and at least one connection component that is configured to connect the PCB to at least one of the substrate or the stiffener of the semiconductor package.

### BRIEF DESCRIPTION OF THE DRAWINGS

Figs. 1A-1E show different views of an example implementation of a semiconductor package described herein.
Figs. 2A-2B show different views of an example implementation of an apparatus described herein.
Figs. 3A-3C show different views of an example implementation of an apparatus described herein.
Figs. 4A-4B show different views of an example implementation of an apparatus described herein.
Fig. 5 is a diagram of example components of a device.

### DETAILED DESCRIPTION

The following detailed description of example implementations refers to the accompanying drawings. The same reference numbers in different drawings may identify the same or similar elements.

A semiconductor package may be mounted to a circuit board by one or more physical connections, such as by solder connections. For example, the semiconductor package may include a ball grid array (BGA) that facilitates connection of the semiconductor package and a circuit board by numerous solder connections (e.g., solder joints). In some cases, the semiconductor package may have a tendency to flex or bow due to temperature changes resulting from operation of the semiconductor package. This can create significant stress on the solder connections. When solder connections between the semiconductor package and the circuit board are unreliable and/or unable to withstand frequent temperature changes, damage (e.g., fracturing) to the solder connections can occur. Damage to one or more solder connections may affect the exchange of electrical signals between the semiconductor package and the circuit board, thereby impairing a functionality of the semiconductor package.

Some implementations described herein provide a stiffener (e.g., a stiffener with an opening) for a semiconductor package. For example, the stiffener may be disposed on a bottom surface of a substrate of the semiconductor package (e.g., on an opposite surface of the substrate on which a semiconductor device of the semiconductor package is disposed). The stiffener may be configured for mechanical connection to a printed circuit board (PCB). Thus, the stiffener improves a resistance of the semiconductor package to flexing or bowing due to temperature fluctuations.

Moreover, in some implementations, the stiffener may extend beyond the footprint of the substrate, which enables the semiconductor package to have a particular footprint and therefore enables the semiconductor package to be included in an apparatus, or other component, that requires the particular footprint. As part of inclusion in the apparatus, a bottom surface of the stiffener can connect with the PCB (e.g., via one or more connection components). The stiffener therefore increases a strength of a mechanical connection between the semiconductor package and the PCB (e.g., as opposed to just a mechanical connection between the PCB and a semiconductor package that does not include the stiffener). Thus, the stiffener improves a resistance of the semiconductor package to flexing or bowing due to temperature fluctuations and an overall size of the semiconductor package can be configured to meet design requirements.

In some implementations, the stiffener may have a "tray" profile such that the stiffener is disposed on the bottom surface and one or more side surfaces of the substrate (but not a top surface of the substrate) of the semiconductor package. Thus, the stiffener may be configured to further improve a resistance of the semiconductor package to flexing or bowing under temperature fluctuations.

Some implementations described herein provide an apparatus that includes the semiconductor package, a PCB, and at least one connection component that is configured to connect the PCB to the semiconductor package (e.g., to at least one of the stiffener or the substrate of the semiconductor package). The at least one connection component may include, for example, another PCB. The other PCB may be disposed within the opening of the stiffener and thereby enable connection (e.g., via one or more BGAs) between the substrate of the semiconductor package and the PCB. As another example, the at least one connection component may include an array of connectors and a socket that are configured to connect to each other, wherein the array of connectors are disposed on the substrate within the opening of the stiffener and the socket is disposed on the PCB. This enables connection between the substrate of the semiconductor package and the PCB. In an additional example, a top surface of the PCB may include a pedestal portion (e.g., defined by a cavity of the PCB) that is disposed within the opening of the stiffener, and the at least one connection component may include a BGA disposed between the substrate and the pedestal portion of the top surface of the PCB to enable connection between the substrate and the PCB.

In this way, some implementations described herein provide a novel apparatus that includes at least one connection component for connecting a semiconductor package with a bottom stiffener to a PCB. Accordingly, the apparatus has an improved resistance to flexing or bowing due to temperature fluctuations as compared to an apparatus that does not include a semiconductor package with a bottom stiffener.

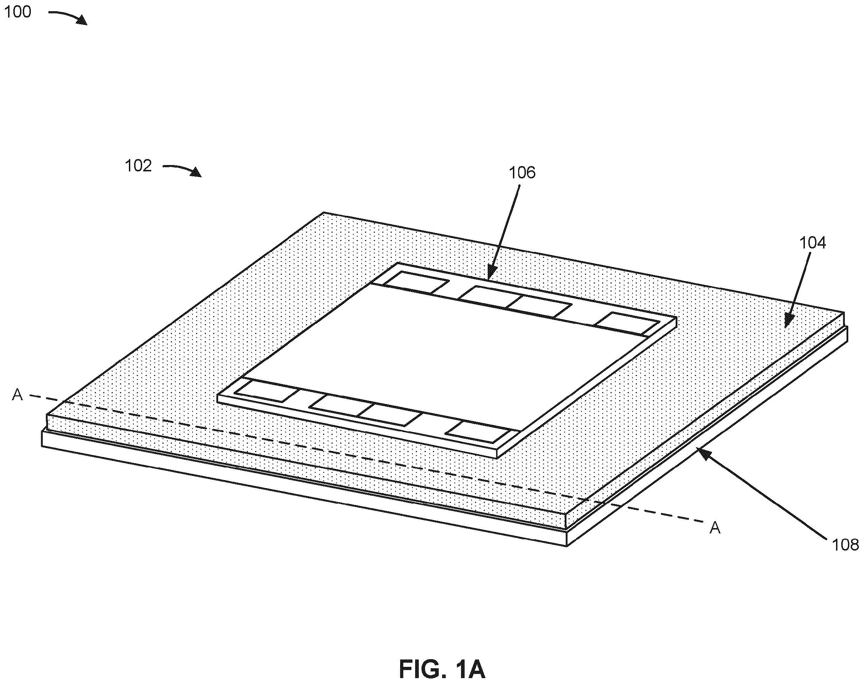

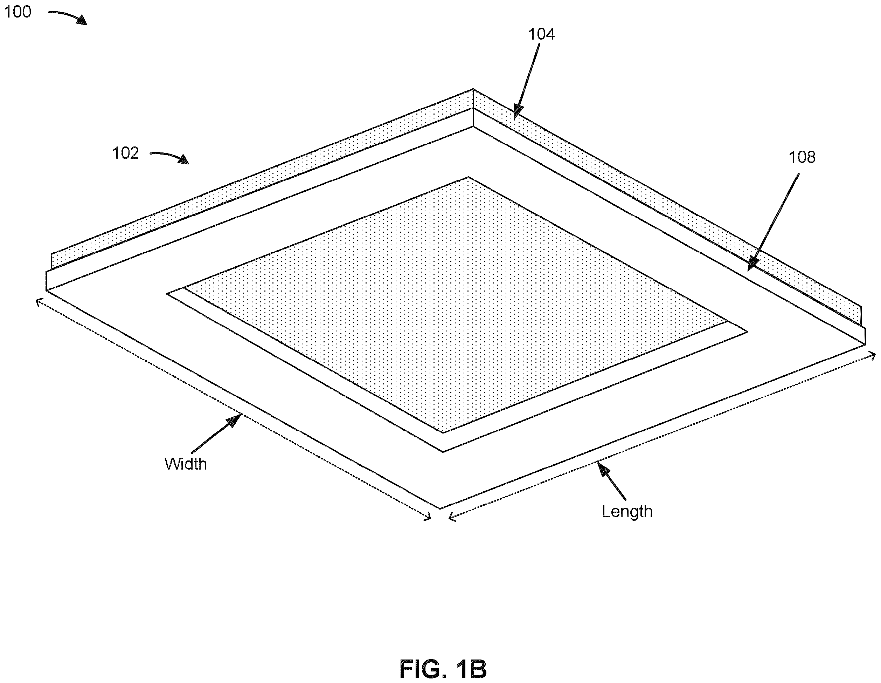

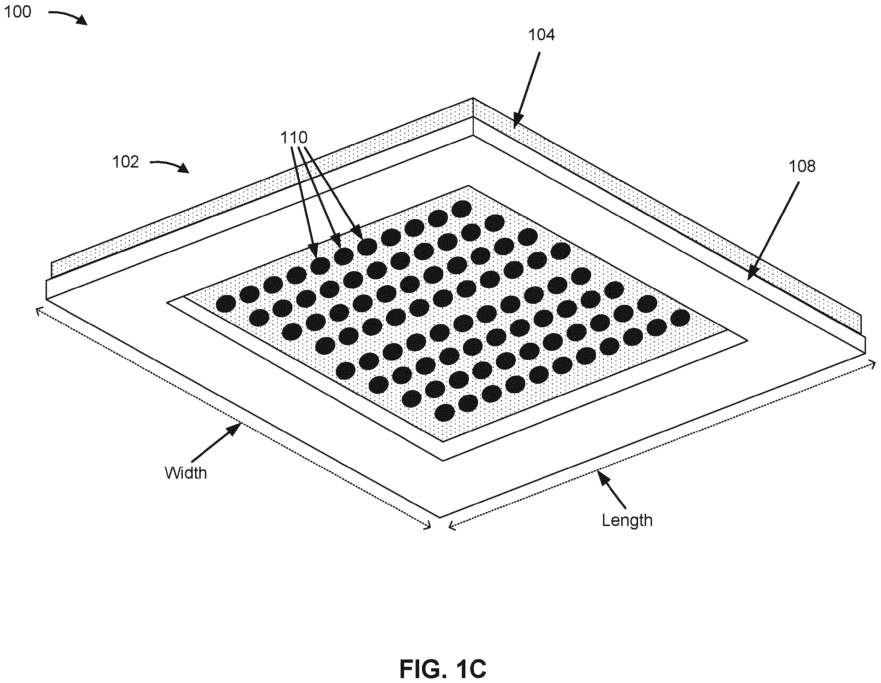

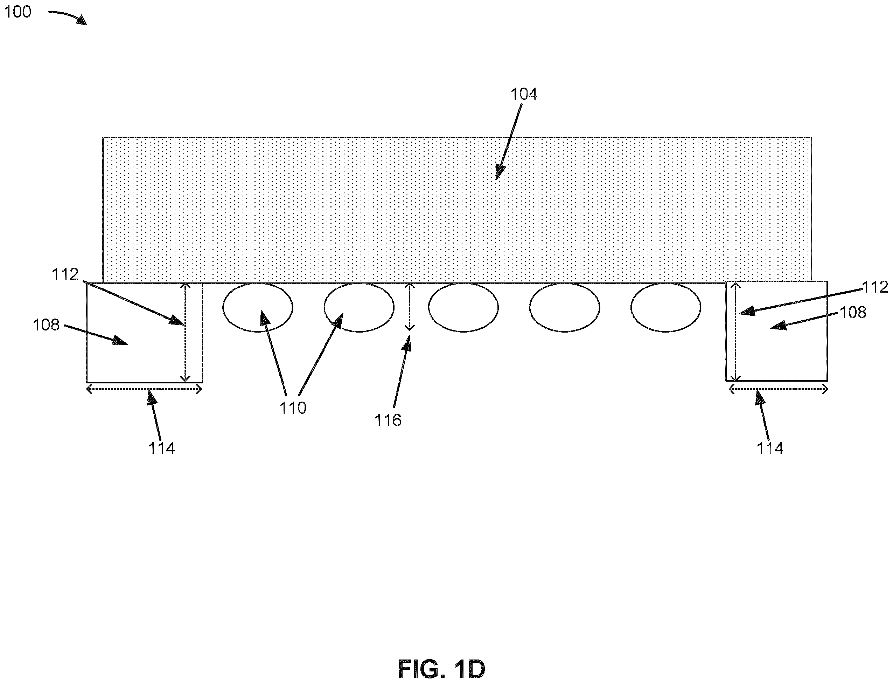

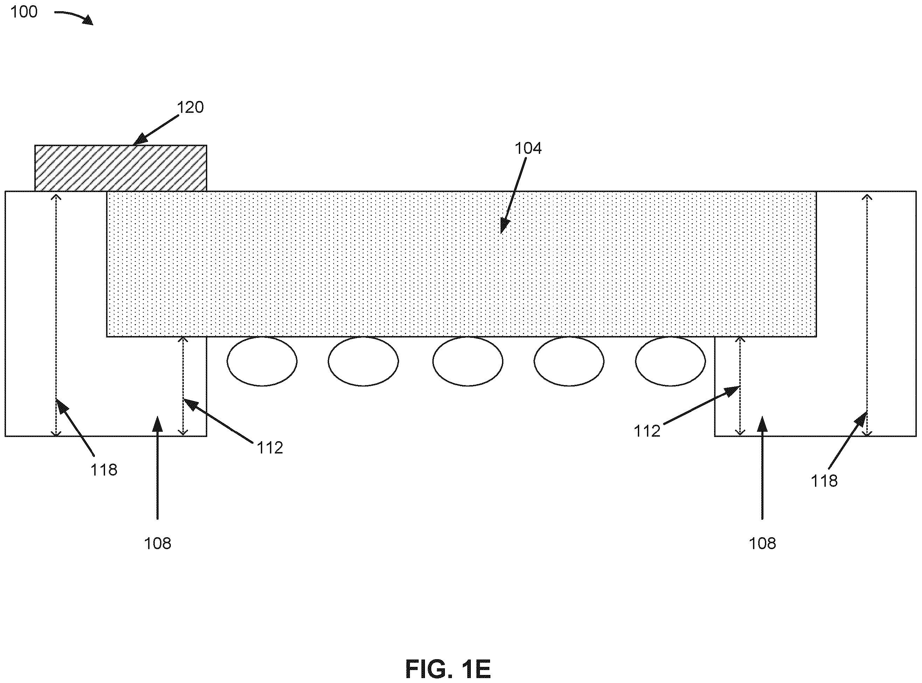

Figs. 1A-1E show different views of an example implementation 100 of a semiconductor package 102 (which may also be referred to as a semiconductor device assembly). Fig. 1A shows a top perspective view of the semiconductor package 102; Fig. 1B shows a bottom perspective view of the semiconductor package 102; Fig. 1C shows another bottom perspective view of the semiconductor package 102; Fig. 1D shows a cross-section view of the semiconductor package 102 along the line A-A shown in Fig. 1A; and Fig. 1E shows a cross-section view of an alternative configuration of the semiconductor package 102 along the line A-A.

The semiconductor package 102 may include a substrate 104 having a first surface (e.g., top surface) and a second surface (e.g., a bottom surface). The substrate 104 may include a conductive or semi-conductive material (e.g., silicon, aluminum, and/or copper, among other examples), may include a PCB material, and/or may include another material. The substrate 104 may be sized and shaped (e.g., rectilinear and planar) to support one or more semiconductor devices 106 on the first surface (e.g., the top surface) of the substrate 104. That is, the semiconductor package 102 may include the one or more semiconductor devices 106, which may be disposed on the first surface of the substrate 104. The one or more semiconductor devices 106 may be disposed on a portion (e.g., a central portion) of the first surface of the substrate 104. The semiconductor device(s) 106 may be electrically connected to the substrate 104 (e.g., by flip-chip bonding and/or by wire bonding).

A semiconductor device 106 may include one or multiple semiconductor dies (e.g., in a stacked arrangement). A semiconductor device 106 may include an integrated circuit chip. In some implementations, a semiconductor device 106 may include an application specific integrated circuit (ASIC), which may include an integrated circuit chip that is customized for a particular use, rather than intended for a general-purpose use. Additionally, or alternatively, a semiconductor device 106 may include an application-specific standard product (ASSP) chip or an industry standard integrated circuit chip, among other examples. Additionally, or alternatively, a semiconductor device 106 may include a memory device (e.g., a device configured to store information), such as a high bandwidth memory (HBM) device that provides a high-speed computer memory interface for three-dimensional stacked synchronous dynamic random-access memory (SDRAM). In some implementations, the semiconductor package 102 may include an ASIC and one or more (e.g., two) memory devices.

In some implementations, the semiconductor package 102 may be a lidless semiconductor package. In the lidless semiconductor package, the semiconductor device(s) 106 may be exposed to allow for direct contact between the semiconductor device(s) 106 and a heat sink (not shown), thereby improving the thermal performance of the semiconductor package 102. Additionally, or alternatively, the semiconductor device(s) 106 may be exposed to allow for direct connection (e.g., to high-speed cables, or other components).

The semiconductor package 102 may include a stiffener 108 (which may also be referred to as a stiffener plate, a stiffener frame, a stiffener ring, or the like). The stiffener 108 may be disposed on the second surface (e.g., the bottom surface) of the substrate 104, such as shown in Figs. 1B-1C. The stiffener 108 may comprise a rigid material, such as silicon, one or more metals (e.g., aluminum, copper, and/or an alloy, among other examples), a polymeric material (e.g., silicone rubber mixed with aluminum particles and zinc oxide), and/or another material. The stiffener 108 may comprise a material with a coefficient of thermal expansion (CTE) that is less than or equal to a CTE threshold. The CTE threshold may be, for example, less than or equal to 1 parts per million per Celsius degree (ppm/°C), 1.3 ppm/°C, 1.5 ppm/°C, 2 ppm/°C, 3 ppm/°C, 5 ppm/°C, 7.5 ppm/°C, 10 ppm/°C, 12.5 ppm/°C, 15 ppm/°C, 17.5 ppm/°C, or 20 ppm/°C. In some implementations, the stiffener 108 may be affixed to the second surface of the substrate 104 by an adhesive, an adhesive tape, or an adhesive film, among other examples, and/or via a connecting material, such as a material comprising solder, glue, and/or epoxy.

In some implementations, the stiffener 108, may be configured to minimize warpage of the semiconductor package 102. For example, the stiffener 108 may be configured to cause warpage of the semiconductor package, during operation of the semiconductor package 102 (e.g., due to temperature fluctuations created by operation of the semiconductor package 102), to be less than or equal to a warpage threshold. The warpage threshold may be, for example, less than or equal to 100 micrometers (µm), 150 µm, 200 µm, 250 µm, 300 µm, 350 µm, or 400 µm.

In some implementations, such as shown in Fig. 1B, the stiffener 108 may be provided on a first portion (e.g., a perimeter portion) of the second surface (e.g., the bottom surface) of the substrate 104. Additionally, the stiffener may not be provided on a second portion (e.g., a central portion) of the second surface of the substrate 104. The second portion of the second surface of the substrate 104 may be separate from (e.g., may not overlap with) the first portion of the bottom surface of the substrate 104. The second portion may be associated with (e.g., aligned with) a portion (e.g., a central portion) of the first surface (e.g., the top surface) of the substrate 104, such as the portion of the first surface of the substrate 104 on which the one or more semiconductor devices 106 are disposed.

Accordingly, the stiffener 108 may have a "frame" profile (e.g., a frame-like structure, such as shown in Figs. 1B-1C), such that the stiffener 108 has a first surface (e.g., a top surface), a second surface (e.g., a bottom surface), and an opening (e.g., a central opening) extending through the first surface and the second surface of the stiffener 108. The first surface (e.g., the top surface) of the stiffener 108 may be disposed on the second surface (e.g., the bottom surface) of the substrate 104, and therefore the first surface of the stiffener 108 may be disposed on the first portion of the second surface of the substrate 104, and may not be disposed on the second portion of the second surface of the substrate 104.

As shown in Figs. 1A-1B, the substrate 104 and the stiffener 108 may each have a width and a length. The lengths and widths of the substrate 104 and the stiffener 108 may each be, for example, greater than or equal to 85 millimeters (mm) and less than or equal to 100 mm. In some implementations, the length of the substrate 104 may be less than or equal to the length of the stiffener 108 and/or the width of the substrate 104 may be less than or equal to the width of the stiffener 108. Accordingly, the stiffener 108 may have a footprint (e.g., defined by the length and width of the stiffener 108) that is greater than or equal to a footprint of the substrate 104 (e.g., defined by the length and width of the substrate 104). Additionally, a difference between the length of the substrate 104 and the length of the stiffener 108 may satisfy (e.g., be less than or equal to) a threshold, and/or a difference between the width of the substrate 104 and the width of the stiffener 108 may satisfy the threshold. The threshold may be, for example, less than or equal to 1 mm, 2 mm, 3 mm, 5 mm, 10 mm, 15 mm, or 20 mm.

The semiconductor package 102 may have a width and a length. The width and length of the semiconductor package 102 may be defined by the width and length of the stiffener 108. That is, the width and length of the semiconductor package 102 may be the width and length of the stiffener 108, and therefore the semiconductor package 102 may have a footprint (e.g., defined by the length and width of the semiconductor package 102) that is the same as the footprint of the stiffener 108 (e.g., defined by the length and width of the stiffener 108). Accordingly, the width and length of the semiconductor package 102 may be, for example, greater than or equal to 85 mm and less than or equal to 100 mm.

As shown in Fig. 1C, the semiconductor package 102 may include one or more connection components 110 that are configured to connect (e.g., structurally connect and/or electrically connect) the semiconductor package 102 to a PCB (e.g., a first PCB 204, a PCB 304, or a PCB 404 described herein). The one or more connection components 110 may include, for example, a BGA (as shown in Fig. 1C), another PCB, an array of connectors (e.g., land grid array (LGA) connectors or pin grid array (PGA) connectors), and/or a socket (e.g., an LGA socket or a PGA socket). The one or more connection components 110 may be disposed on a second surface (e.g., a bottom surface) of the semiconductor package 102. For example, as shown in Fig. 1C, the one or more connection components 110 may be disposed on the second portion of the second surface (e.g., the bottom surface) of the substrate 104 (e.g., the portion of the second surface of the substrate 104 upon which the stiffener 108 is not disposed).

As shown in Fig. 1D, the stiffener 108 may have a thickness 112. The thickness 112 may be, for example, greater than or equal to 1 mm and less than or equal to 10 mm. In some implementations, the thickness 112 may be greater than or equal to 0.4 mm, 0.5 mm, 0.6 mm, 0.7 mm, 0.8 mm, or 0.9 mm. As further shown in Fig. 1D (and in Fig. 1C), when the stiffener 108 has a frame profile, the stiffener 108 may have a frame width 114 (e.g., a width of each length portion of the stiffener 108). The frame width 114 may be, for example, greater than or equal to 2 mm and less than or equal to 20 mm. In some implementations, the frame width 114 may be greater than or equal to 1.5 mm, 1.6 mm, 1.7 mm, 1.8 mm, or 1.9 mm. Additionally, when the stiffener 108 has a frame profile, the stiffener 108 may have a frame length 115 (e.g., a length of each width portion of the stiffener 108, shown in Fig. 1C). The frame length 115 may be, for example, greater than or equal to 2 mm and less than or equal to 20 mm. In some implementations, the frame length 115 may be greater than or equal to 1.5 mm, 1.6 mm, 1.7 mm, 1.8 mm, or 1.9 mm. In some implementations, the frame width 114 and the frame length 115 of the stiffener 108 may be the same (e.g., equal to each other), or, alternatively, may be different (e.g., not equal to each other).

As further shown in Fig. 1D, the one or more connection components 110 may have a thickness 116. The thickness 116 may be, for example, greater than or equal to 0.1 mm and less than or equal to 4 mm. In some implementations, the thickness 116 may be less than or equal to the thickness 112. That is the one or more connection components may be less thick, or the same thickness as, the stiffener 108. In some implementations, the thickness 112 of the stiffener 108 may be greater than or equal to a threshold percentage of the thickness 116 of the one or more connection components 110. The threshold percentage may be greater than or equal to, for example, 75%, 76%, 77%, 78%, 79%, 80%, 85%, 90%, 95%, 100%, 110%, 125%, or 150%. In this way, the one or more connection components 110 may enable connection to a portion of a PCB, or another component, that fits within the opening of the stiffener 108.

Fig. 1E, shows an alternative configuration of the semiconductor package 102, where a portion of the stiffener 108 is disposed on one or more side surfaces of the substrate 104. That is, a first portion of the stiffener 108 may be disposed on the second surface of the substrate 104 (e.g., the first portion of the second surface of the substrate 104), and a second portion of the stiffener 108 may be disposed on the one or more side surfaces of the substrate 104 (but not the first surface of the substrate 104). In this way, the stiffener 108 may have a "tray" profile (e.g., a tray-like structure). In some implementations, the first portion of the stiffener 108 (e.g., the first surface of the first portion stiffener 108) may be affixed to the second surface of the substrate 104 and/or the second portion of the stiffener 108 (e.g., a side surface of the second portion of the stiffener 108) may be disposed on the one or more side surfaces of the substrate 104 by an adhesive, an adhesive tape, or an adhesive film, among other examples, and/or via a connecting material, such as a material comprising solder, glue, and/or epoxy.

As further shown in Fig. 1E, the stiffener 108 may have a tray thickness 118. The tray thickness 118 may be, for example, greater than or equal to 2 mm and less than or equal to 10 mm. In some implementations, the tray thickness 118 may be equal to a sum of the thickness 112 of the stiffener 108 and a thickness of the substrate 104 (e.g., within a threshold, such as 1 mm), such that a top surface of the stiffener 108 is flush with a top surface of the substrate 104. Additionally, the stiffener 108 may have a tray width 120 (e.g., as measured from a side of the substrate 104). The tray width 120 may be, for example, greater than or equal to 1 mm and less than or equal to 30 mm. Accordingly, the stiffener 108 may extend beyond the footprint of the substrate 104, which enables the semiconductor package 102 to have a particular footprint and therefore enables the semiconductor package 102 to be included in an apparatus, or other component, that requires the particular footprint.

Accordingly, as further shown in Fig. 1E, another component 122 may be disposed on the top surface of the stiffener 108 and the top surface of the substrate 104 (e.g., such that the other component 122 spans the top surface of the stiffener 108 and the top surface of the substrate 104). The other component 122 may be, for example, a stiffener component that is configured to connect (e.g., structurally connect) the stiffener 108 and the substrate 104 and thereby minimize warpage of the substrate 104.

As indicated above, Figs. 1A-1E are provided as an example. Other examples may differ from what is described with regard to Figs. 1A-1E.

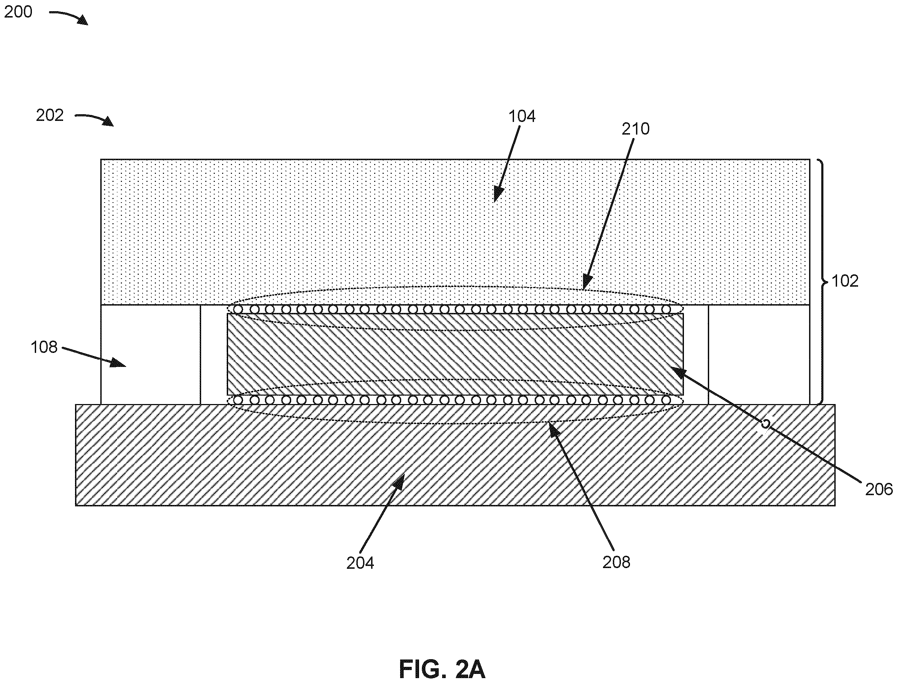

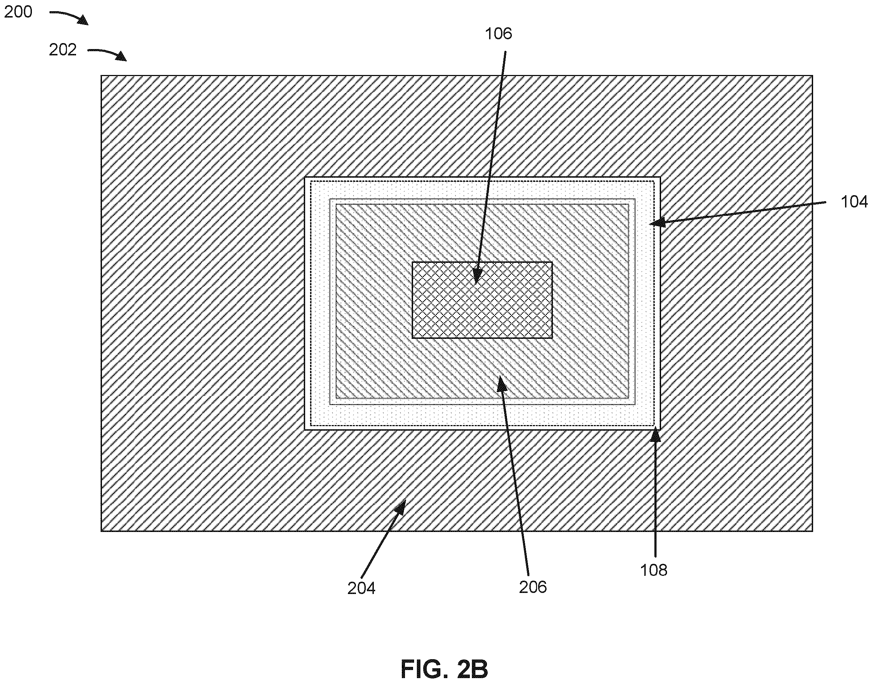

Figs. 2A-2B show different views of an example implementation 200. Implementation 200 may comprise an apparatus 202 (e.g., a semiconductor apparatus) that includes the semiconductor package 102 (e.g., that includes the substrate 104, the semiconductor device 106, and/or the stiffener 108), a first PCB 204, and a second PCB 206 (e.g., another PCB in addition to the first PCB 204). Fig. 2A shows a cross-section view of the apparatus 202, and Fig. 2B shows a top-down view of the apparatus 202.

In some implementations, the semiconductor package 102 may be disposed on a surface (e.g., a top surface) of the first PCB 204. For example, as shown in Fig. 2A, a first surface (e.g., a top surface) of the stiffener 108 may be disposed on a surface (e.g., a bottom surface) of the substrate 104, and a second surface (e.g., a bottom surface) of the stiffener 108 (e.g., that comprises a bottom surface of the semiconductor package 102) may be disposed on a surface (e.g., a top surface) of the first PCB 204.

As described elsewhere herein, the stiffener 108 may include an opening. Accordingly, the second PCB 206 may be disposed within the opening of the stiffener 108. For example, as shown in Figs. 2A and 2B, the second PCB 206 may be placed within the opening of the stiffener 108 such that the stiffener 108 surrounds the second PCB 206. In some implementations, a first surface (e.g., a top surface) of the second PCB 206 may be disposed on the surface (e.g., the bottom surface) of the substrate 104, and therefore may be disposed on a surface (e.g., a bottom surface) of the semiconductor package 102. For example, as shown in Fig. 2A, the first surface (e.g., the top surface) of the second PCB 206 may be disposed on a portion of the surface (e.g., a portion of the bottom surface) of the substrate 104 that is associated with the opening of the stiffener 108, such as on a portion of the surface of the substrate 104 upon which the first surface (e.g., the top surface) of the stiffener 108 is not disposed. Additionally, or alternatively, a second surface (e.g., a bottom surface) of the second PCB 206 may be disposed on the surface (e.g., the top surface) of the first PCB 204. For example, as shown in Fig. 2A, the second surface of the second PCB 206 may be disposed on a portion of the surface of the first PCB 204 upon which the second surface (e.g., the bottom surface) of the stiffener 108 is not disposed.

In some implementations, the second surface (e.g., the bottom surface) of the second PCB 206 may be connected (e.g., structurally connected and/or electrically connected) to the surface (e.g., the top surface) of the first PCB 204 via a first BGA 208. For example, as shown in Fig. 2A, the first BGA 208 may be disposed between the second surface of the second PCB 206 and the surface of the first PCB 204, and may be configured to connect the second surface of the second PCB 206 and the surface of the first PCB 204. Additionally, or alternatively, the first surface (e.g., the top surface) of the second PCB 206 may be connected (e.g., structurally connected and/or electrically connected) to the surface (e.g., the bottom surface) of the substrate 104 (e.g., the bottom surface of the semiconductor package 102) via a second BGA 210. For example, as shown in Fig. 2A, the second BGA 210 may be disposed between the first surface of the second PCB 206 and a portion of the surface of the substrate 104 that is associated with the opening of the stiffener 108, such as on a portion of the surface of the substrate 104 upon which the first surface (e.g., the top surface) of the stiffener 108 is not disposed.

In some implementations, the second PCB 206, the first BGA 208, and/or the second BGA 210 may be referred to as one or more connection components (e.g., the one or more connection components 110 described elsewhere herein). Each connection component may be configured to connect (e.g., structurally connect and/or electrically connect) the first PCB 204 and the semiconductor package 102 (e.g., connect the first PCB 204 to at least one of the substrate 104 and/or the stiffener 108 of the semiconductor package 102), as described herein.

As indicated above, Figs. 2A-2B are provided as an example. Other examples may differ from what is described with regard to Figs. 2A-2B.

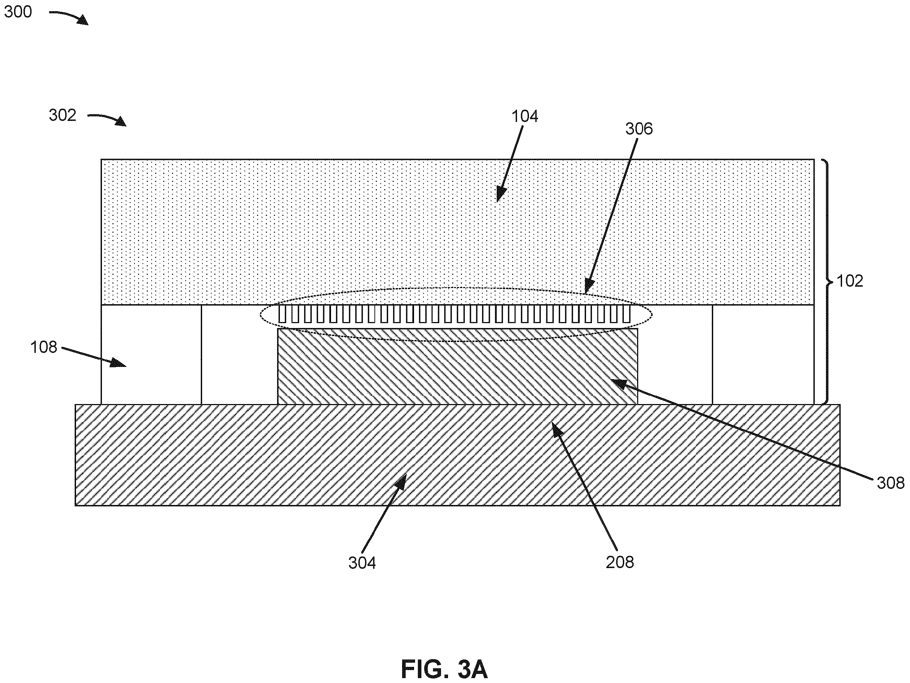

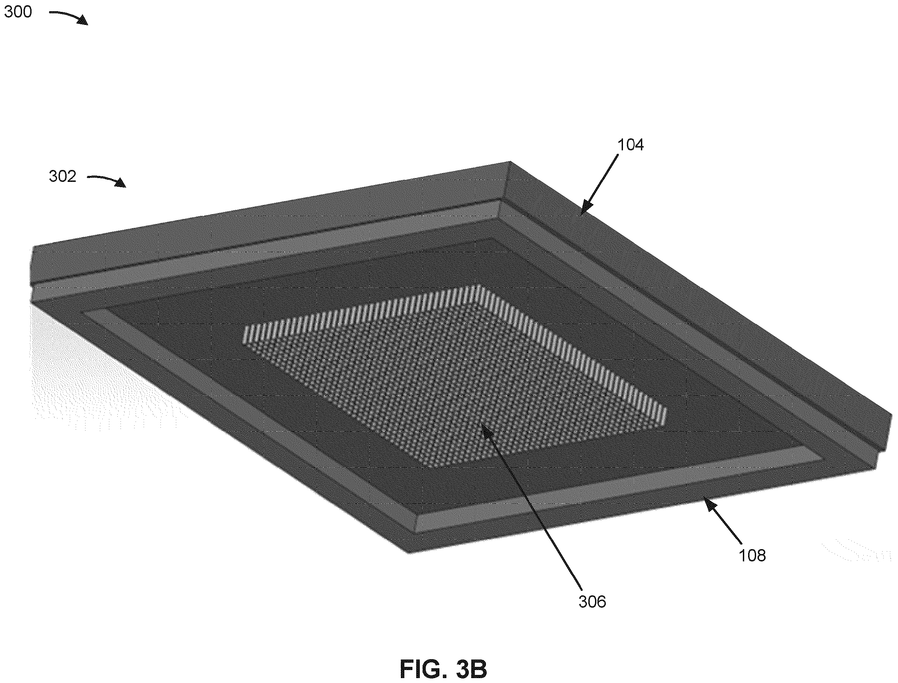

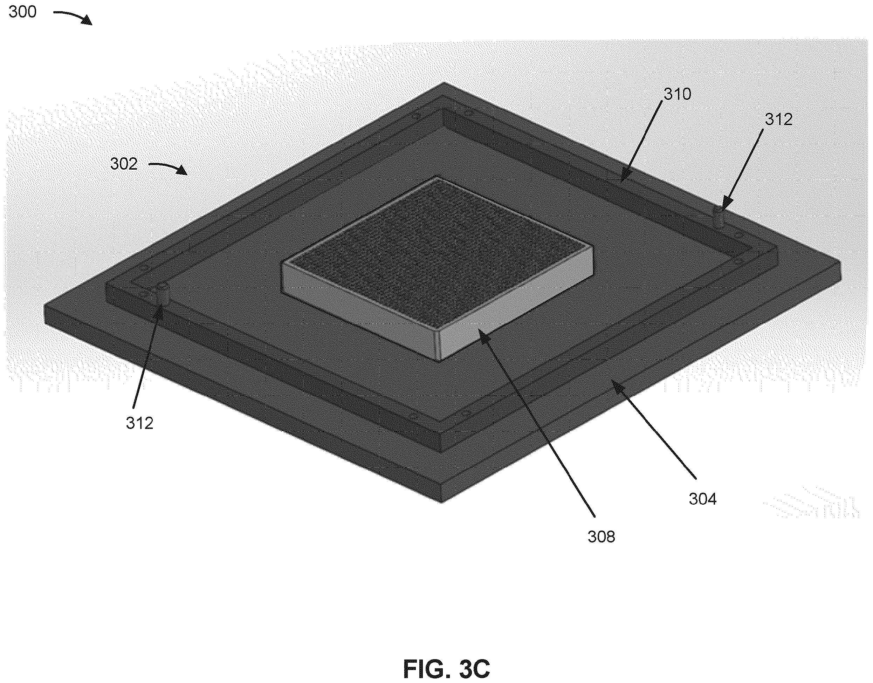

Figs. 3A-3C show different views of an example implementation 300. Implementation 300 may comprise an apparatus 302 (e.g., a semiconductor apparatus) that includes the semiconductor package 102 (e.g., that includes the substrate 104, the semiconductor device 106, and/or the stiffener 108) and a PCB 304. Fig. 3A shows a cross-section view of the apparatus 302; Fig. 3B shows a perspective view of a portion of the apparatus 302 that includes the semiconductor package 102; and Fig. 3C shows a perspective view of a portion of the apparatus 302 that includes the PCB 304.

In some implementations, the semiconductor package 102 may be disposed on a surface (e.g., a top surface) of the PCB 304. For example, as shown in Fig. 3A, a first surface (e.g., a top surface) of the stiffener 108 may be disposed on a surface (e.g., a bottom surface) of the substrate 104, and a second surface (e.g., a bottom surface) of the stiffener 108 (e.g., that comprises a bottom surface of the semiconductor package 102) may be disposed on a surface (e.g., a top surface) of the PCB 304.

As shown in Figs. 3A-3C, the apparatus 302 may include an array of connectors 306 and a socket 308 (e.g., that are configured to connect to each other). For example, the array of connectors 306 may include LGA connectors, and the socket 308 may include an LGA socket. As another example, the array of connectors 306 may include PGA connectors, and the socket 308 may include a PGA socket.

The array of connectors 306 may be disposed on the surface (e.g., the bottom surface) of the substrate 104. For example, as shown in Figs. 3A-3B, the array of connectors 306 may be disposed on a portion of the surface of the substrate 104 that is associated with an opening of the stiffener 108, such as on a portion of the surface of the substrate 104 upon which the first surface (e.g., the top surface) of the stiffener 108 is not disposed. Accordingly, the array of connectors 306 may be disposed within the opening of the stiffener 108. For example, as further shown in Figs. 3A-3B, the array of connectors 306 may be placed within the opening of the stiffener 108 such that the stiffener 108 surrounds the array of connectors 306. The socket 308 may be disposed on the surface (e.g., the top surface) of the PCB 304. For example, as shown in Figs. 3A and 3C, the socket 308 may be disposed on a portion of the surface of the PCB 304 upon which the second surface (e.g., the bottom surface) of the stiffener 108 is not disposed.

In some implementations, the array of connectors 306 and/or the socket 308 may be referred to as one or more connection components (e.g., the one or more connection components 110 described elsewhere herein). Each connection component may be configured to connect (e.g., structurally connect and/or electrically connect) the PCB 304 and the semiconductor package 102 (e.g., connect the PCB 304 to at least one of the substrate 104 and/or the stiffener 108 of the semiconductor package 102), as described herein.

As shown in Fig. 3C, the apparatus 302 may include a mounting component 310, which may include one or more alignment components 312. The mounting component 310 may be configured to facilitate mounting of the apparatus 302 on another apparatus or component (e.g., within a device or assembly). The mounting component 310 may comprise, for example, a rigid material, such as silicon, one or more metals (e.g., aluminum, copper, and/or an alloy, among other examples), a polymeric material (e.g., silicone rubber mixed with aluminum particles and zinc oxide), and/or another material. The one or more alignment components 312 may be configured to facilitate mounting of the apparatus 302 on the other apparatus or component. For example, the one or more alignment components 312 may include one or more pegs that interface with (e.g., insert into) corresponding recesses of the other apparatus or component to ensure proper mounted alignment of the apparatus 302 with respect to the other apparatus or component.

As indicated above, Figs. 3A-3C are provided as an example. Other examples may differ from what is described with regard to Figs. 3A-3C.

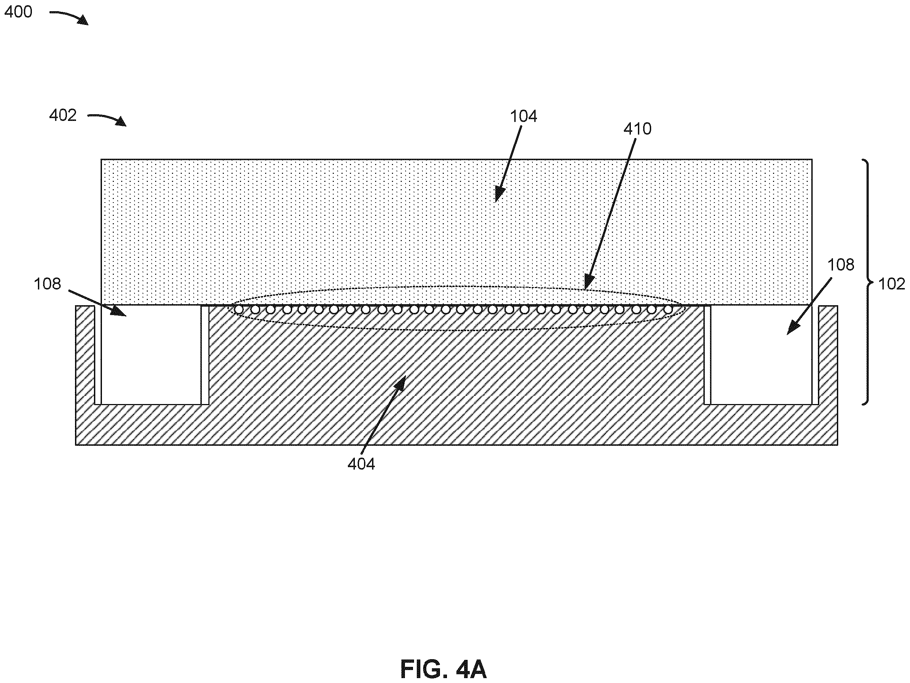

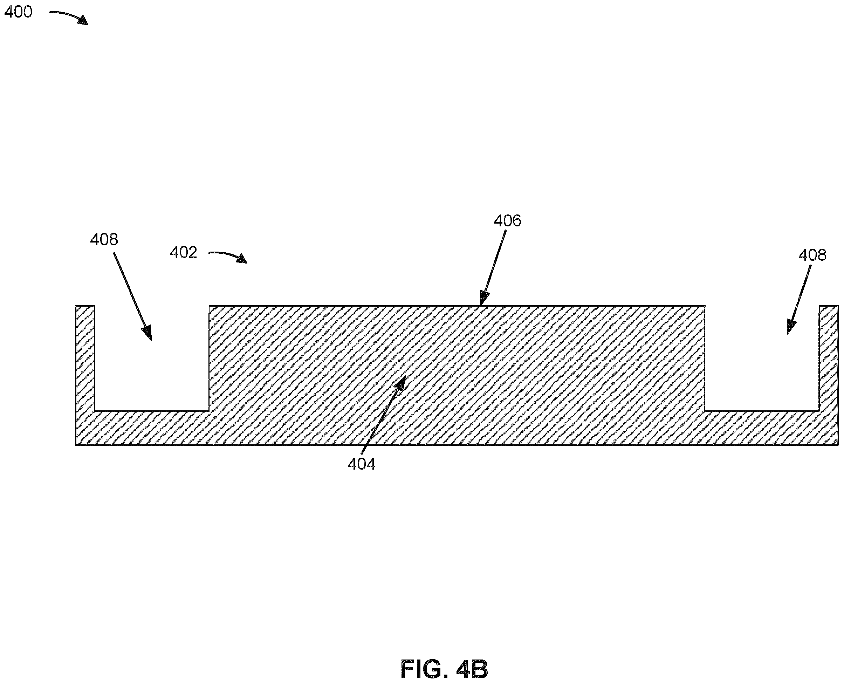

Figs. 4A-4B show different views of an example implementation 400. Implementation 400 may comprise an apparatus 402 (e.g., a semiconductor apparatus) that includes the semiconductor package 102 (e.g., that includes the substrate 104, the semiconductor device 106, and/or the stiffener 108) and a PCB 404. Fig. 4A shows a cross-section view of the apparatus 402, and Fig. 4B shows a cross-section view of the PCB 404.

In some implementations, a surface (e.g., a top surface) of the PCB 404 may include a pedestal portion 406 and a cavity 408. For example, as shown in Fig. 4B, the cavity 408 may define the pedestal portion 406 of the surface of the PCB 404 (e.g., the cavity 408 may surround the pedestal portion 406, such as to form a moat, and thereby define the pedestal portion 406). The cavity 408 may correspond to the stiffener 108 of the semiconductor package 102. For example, the cavity 408 may be configured to hold the stiffener 108 within the cavity 408, and therefore the cavity 408 may have a frame profile (e.g., that corresponds to the frame profile of the stiffener 108). The pedestal portion 406 may correspond to the opening of the stiffener 108. For example, the pedestal portion 406 may be configured to fit within the opening of the stiffener 108 (e.g., such that the pedestal portion 406 is disposed within the opening of the stiffener 108 when the stiffener 108 is disposed within the cavity 408).

In some implementations, the semiconductor package 102 may be disposed on a surface (e.g., a top surface) of the PCB 404. For example, as shown in Fig. 4A, a first surface (e.g., a top surface) of the stiffener 108 may be disposed on a surface (e.g., a bottom surface) of the substrate 104, and the surface of the substrate 104 may be disposed on the surface of the PCB 404 (e.g., on the pedestal portion 406 of the surface of the PCB 404).

In some implementations, the surface (e.g., the bottom surface) of the semiconductor package 102 may be connected (e.g., structurally connected and/or electrically connected) to the surface (e.g., the top surface) of the PCB 404 via a BGA 410. For example, as shown in Fig. 4A, the BGA 410 may be disposed between the pedestal portion 406 of the surface (e.g., the top surface) of the PCB 404 and the surface (e.g., the bottom surface) of the substrate 104 (e.g., a portion of the surface of the substrate 104 that is associated with the opening of the stiffener 108). As an additional, or alternative, example, the BGA 410 may be disposed between the second surface (e.g., the bottom surface) of the stiffener 108 and a portion of the surface of the PCB 404 that is associated with the cavity 408. In some implementations, the BGA 410 may be referred to as one or more connection components (e.g., the one or more connection components 110 described elsewhere herein). Each connection component may be configured to connect (e.g., structurally connect and/or electrically connect) the PCB 404 and the semiconductor package 102 (e.g., connect the PCB 404 to at least one of the substrate 104 and/or the stiffener 108 of the semiconductor package 102), as described herein.

As indicated above, Figs. 4A-4B are provided as an example. Other examples may differ from what is described with regard to Figs. 4A-4B.

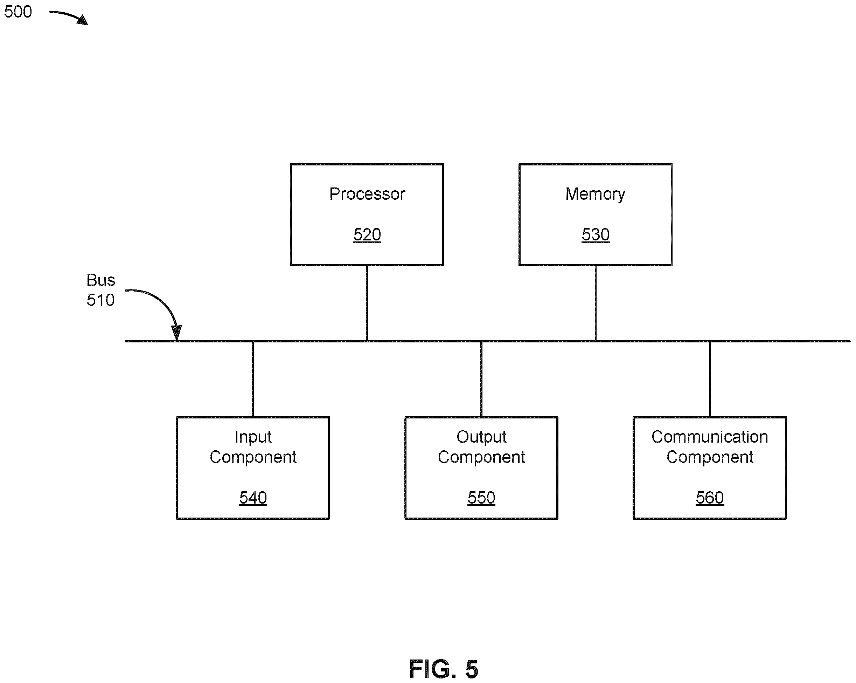

Fig. 5 is a diagram of example components of a device 500, which may correspond to the semiconductor package 102, the semiconductor device 106, the apparatus 202, the apparatus 302, and/or the apparatus 402, among other examples. In some implementations, the semiconductor package 102, the semiconductor device 106, the apparatus 202, the apparatus 302, and/or the apparatus 402 may include one or more devices 500 and/or one or more components of the device 500. As shown in Fig. 5, the device 500 may include a bus 510, a processor 520, a memory 530, an input component 540, an output component 550, and/or a communication component 560.

The bus 510 may include one or more components that enable wired and/or wireless communication among the components of the device 500. The bus 510 may couple together two or more components of Fig. 5, such as via operative coupling, communicative coupling, electronic coupling, and/or electric coupling. For example, the bus 510 may include an electrical connection (e.g., a wire, a trace, and/or a lead) and/or a wireless bus. The processor 520 may include a central processing unit, a graphics processing unit, a microprocessor, a controller, a microcontroller, a digital signal processor, a field-programmable gate array, an application-specific integrated circuit, and/or another type of processing component. The processor 520 may be implemented in hardware, firmware, or a combination of hardware and software. In some implementations, the processor 520 may include one or more processors capable of being programmed to perform one or more operations or processes described elsewhere herein.

The memory 530 may include volatile and/or nonvolatile memory. For example, the memory 530 may include random access memory (RAM), read only memory (ROM), a hard disk drive, and/or another type of memory (e.g., a flash memory, a magnetic memory, and/or an optical memory). The memory 530 may include internal memory (e.g., RAM, ROM, or a hard disk drive) and/or removable memory (e.g., removable via a universal serial bus connection). The memory 530 may be a non-transitory computer-readable medium. The memory 530 may store information, one or more instructions, and/or software (e.g., one or more software applications) related to the operation of the device 500. In some implementations, the memory 530 may include one or more memories that are coupled (e.g., communicatively coupled) to one or more processors (e.g., processor 520), such as via the bus 510. Communicative coupling between a processor 520 and a memory 530 may enable the processor 520 to read and/or process information stored in the memory 530 and/or to store information in the memory 530.

The input component 540 may enable the device 500 to receive input, such as user input and/or sensed input. For example, the input component 540 may include a touch screen, a keyboard, a keypad, a mouse, a button, a microphone, a switch, a sensor, a global positioning system sensor, an accelerometer, a gyroscope, and/or an actuator. The output component 550 may enable the device 500 to provide output, such as via a display, a speaker, and/or a light-emitting diode. The communication component 560 may enable the device 500 to communicate with other devices via a wired connection and/or a wireless connection. For example, the communication component 560 may include a receiver, a transmitter, a transceiver, a modem, a network interface card, and/or an antenna.

The device 500 may perform one or more operations or processes described herein. For example, a computer-readable medium (e.g., memory 530 and/or a transmission medium) may provide a set of instructions (e.g., one or more instructions or code) for execution by the processor 520. The processor 520 may execute the set of instructions to perform one or more operations or processes described herein. In some implementations, execution of the set of instructions, by one or more processors 520, causes the one or more processors 520 and/or the device 500 to perform one or more operations or processes described herein. In some implementations, hardwired circuitry may be used instead of or in combination with the instructions to perform one or more operations or processes described herein. Additionally, or alternatively, the processor 520 may be configured to perform one or more operations or processes described herein. Thus, implementations described herein are not limited to any specific combination of hardware circuitry and software.

The number and arrangement of components shown in Fig. 5 are provided as an example. The device 500 may include additional components, fewer components, different components, or differently arranged components than those shown in Fig. 5. Additionally, or alternatively, a set of components (e.g., one or more components) of the device 500 may perform one or more functions described as being performed by another set of components of the device 500.

Therefore, from one perspective, there have been described that apparatus, may include a PCB, a semiconductor package that includes a substrate and a stiffener with an opening, and at least one connection component. The stiffener is disposed on a top surface of the PCB. The at least one connection component is configured to connect the PCB to the semiconductor package. The at least one connection component may include another PCB that is disposed on the substrate within the opening of the stiffener and on the PCB. The at least one connection component may include an array of connectors that are disposed on the substrate within the opening of the stiffener, and may include a socket disposed on the PCB. The at least one connection component may include a BGA that is disposed on the substrate within the opening of the stiffener and on the PCB and on a pedestal portion of a surface of the PCB.

Further examples are set out in the following numbered clauses.

Clause 1. An apparatus, comprising: a printed circuit board (PCB); a semiconductor package disposed on a top surface of the PCB that includes a substrate and a stiffener, wherein a top surface of the stiffener is disposed on a bottom surface of the substrate, and wherein a bottom surface of the stiffener is disposed on a top surface of the PCB; and at least one connection component that is configured to connect the PCB and the semiconductor package.

Clause 2. The apparatus of clause 1, wherein the at least one connection component includes another PCB, wherein: a bottom surface of the other PCB is disposed on the top surface of the PCB, and a top surface of the other PCB is disposed on a bottom surface of the substrate.

Clause 3. The apparatus of clause 2, wherein: the bottom surface of the other PCB is connected to the top surface of the PCB via a first ball grid array (BGA), and the top surface of the other PCB is connected to the bottom surface of the substrate via a second BGA.

Clause 4. The apparatus of clause 2 or 3, wherein the stiffener has a top surface, a bottom surface, and an opening extending through the top surface and the bottom surface of the stiffener, and wherein: the other PCB is disposed within the opening of the stiffener, and the top surface of the other PCB is disposed on a portion of a bottom surface of the substrate that is associated with the opening of the stiffener.

Clause 5. The apparatus of any preceding clause, wherein the at least one connection component includes an array of connectors and a socket that are configured to connect to each other, wherein: the array of connectors is disposed on a bottom surface of the substrate, and the socket is disposed on the top surface of the PCB.

Clause 6. The apparatus of clause 5, wherein the stiffener has a top surface, a bottom surface, and an opening extending through the top surface and the bottom surface of the stiffener, and wherein: the array of connectors is disposed within the opening of the stiffener, and the array of connectors is disposed on a portion of a bottom surface of the substrate that is associated with the opening of the stiffener.

Clause 7. The apparatus of clause 5 or 6, wherein: the array of connectors includes land grid array (LGA) connectors, and the socket includes an LGA socket.

Clause 8. The apparatus of clause 5 or 6, wherein: the array of connectors includes pin grid array (PGA) connectors, and the socket includes a PGA socket.

Clause 9. The apparatus of any preceding clause, wherein the at least one connection component includes a ball grid array (BGA), wherein: the top surface of the PCB includes a pedestal portion, and the BGA is disposed on the pedestal portion and on the bottom surface of the substrate.

Clause 10. The apparatus of clause 9, wherein the stiffener has a top surface, a bottom surface, and an opening extending through the top surface and the bottom surface of the stiffener, and wherein: the pedestal portion of the top surface of the PCB is disposed within the opening of the stiffener, and the BGA is disposed on a portion of a bottom surface of the substrate that is associated with the opening of the stiffener.

Clause 11. The apparatus of clause 10, wherein the top surface of the PCB includes a cavity that surrounds the pedestal portion, wherein: the stiffener is disposed within the cavity.

Clause 12. An apparatus, comprising: a substrate; a stiffener with an opening disposed on a bottom surface of the substrate; a printed circuit board (PCB) disposed on a bottom surface of the stiffener; and at least one connection component that is configured to connect the PCB to at least one of the stiffener or the substrate.

Clause 13. The apparatus of clause 12, wherein the at least one connection component includes another PCB, wherein: the other PCB is disposed within the opening of the stiffener, a top surface of the other PCB is disposed on a portion of the bottom surface of the substrate that is associated with the opening of the stiffener, and a bottom surface of the other PCB is disposed on the top surface of the PCB.

Clause 14. The apparatus of clause 12 or 13, wherein the at least one connection component includes an array of connectors and a socket, wherein: the array of connectors is disposed within the opening of the stiffener, the array of connectors is disposed on a portion of the bottom surface of the substrate that is associated with the opening of the stiffener, and the socket is disposed on a top surface of the PCB.

Clause 15. The apparatus of clause 12, 13 or 14, wherein the at least one connection component includes a ball grid array (BGA), wherein: a top surface of the PCB includes a pedestal portion, the pedestal portion of the top surface of the PCB is disposed within the opening of the stiffener, and the BGA is disposed on the pedestal portion of the top surface of the PCB and on a portion of a bottom surface of the substrate that is associated with the opening of the stiffener.

Clause 16. An apparatus, comprising: a printed circuit board (PCB); a semiconductor package that includes a substrate and a stiffener, wherein the stiffener is disposed on a top surface of the PCB; and at least one connection component that is configured to connect the PCB to at least one of the substrate or the stiffener of the semiconductor package.

Clause 17. The apparatus of clause 16, wherein the at least one connection component includes another PCB, wherein: a top surface of the other PCB is disposed on a portion of a bottom surface of the substrate that is associated with an opening of the stiffener, and a bottom surface of the other PCB is disposed on the top surface of the PCB.

Clause 18. The apparatus of clause 16 or 17, wherein the at least one connection component includes an array of connectors and a socket, wherein: the array of connectors is disposed on a portion of a bottom surface of the substrate that is associated with an opening of the stiffener, and the socket is disposed on a top surface of the PCB.

Clause 19. The apparatus of clause 16, 17 or 18, wherein the at least one connection component includes a ball grid array (BGA), wherein: the top surface of the PCB includes a pedestal portion, and the BGA is disposed on the pedestal portion of the top surface of the PCB and on a portion of a bottom surface of the substrate that is associated with an opening of the stiffener.

Clause 20. The apparatus of clause 19, wherein the top surface of the PCB includes a cavity that defines the pedestal portion of the top surface of the PCB.

The foregoing disclosure provides illustration and description, but is not intended to be exhaustive or to limit the implementations to the precise forms disclosed. Modifications and variations may be made in light of the above disclosure or may be acquired from practice of the implementations.

As used herein, satisfying a threshold may, depending on the context, refer to a value being greater than the threshold, greater than or equal to the threshold, less than the threshold, less than or equal to the threshold, equal to the threshold, not equal to the threshold, or the like.

As used herein, the term "component" is intended to be broadly construed as hardware, firmware, or a combination of hardware and software. It will be apparent that systems and/or methods described herein may be implemented in different forms of hardware, firmware, and/or a combination of hardware and software. The actual specialized control hardware or software code used to implement these systems and/or methods is not limiting of the implementations. Thus, the operation and behavior of the systems and/or methods are described herein without reference to specific software code - it being understood that software and hardware can be used to implement the systems and/or methods based on the description herein.

Even though particular combinations of features are recited in the claims and/or disclosed in the specification, these combinations are not intended to limit the disclosure of various implementations. In fact, many of these features may be combined in ways not specifically recited in the claims and/or disclosed in the specification. Although each dependent claim listed below may directly depend on only one claim, the disclosure of various implementations includes each dependent claim in combination with every other claim in the claim set. As used herein, a phrase referring to "at least one of' a list of items refers to any combination of those items, including single members. As an example, "at least one of: a, b, or c" is intended to cover a, b, c, a-b, a-c, b-c, and a-b-c, as well as any combination with multiple of the same item.

No element, act, or instruction used herein should be construed as critical or essential unless explicitly described as such. Also, as used herein, the articles "a" and "an" are intended to include one or more items, and may be used interchangeably with "one or more." Further, as used herein, the article "the" is intended to include one or more items referenced in connection with the article "the" and may be used interchangeably with "the one or more." Furthermore, as used herein, the term "set" is intended to include one or more items (e.g., related items, unrelated items, or a combination of related and unrelated items), and may be used interchangeably with "one or more." Where only one item is intended, the phrase "only one" or similar language is used. Also, as used herein, the terms "has," "have," "having," or the like are intended to be open-ended terms. Further, the phrase "based on" is intended to mean "based, at least in part, on" unless explicitly stated otherwise. Also, as used herein, the term "or" is intended to be inclusive when used in a series and may be used interchangeably with "and/or," unless explicitly stated otherwise (e.g., if used in combination with "either" or "only one of'). Further, spatially relative terms, such as "below," "lower," "bottom," "above," "upper," "top," and the like, may be used herein for ease of description to describe one element or feature's relationship to another element(s) or feature(s) as illustrated in the figures. The spatially relative terms are intended to encompass different orientations of the apparatus, device, and/or element in use or operation in addition to the orientation depicted in the figures. The apparatus may be otherwise oriented (rotated 90 degrees or at other orientations) and the spatially relative descriptors used herein may likewise be interpreted accordingly.

## Claims

1. An apparatus, comprising:
a printed circuit board (PCB);
a semiconductor package that includes a substrate and a stiffener,
wherein the stiffener is disposed on a top surface of the PCB; and
at least one connection component that is configured to connect the PCB to at least one of the substrate or the stiffener of the semiconductor package.

2. The apparatus of claim 1, wherein the at least one connection component includes another PCB, wherein:
a top surface of the other PCB is disposed on a portion of a bottom surface of the substrate that is associated with an opening of the stiffener, and
a bottom surface of the other PCB is disposed on the top surface of the PCB.

3. The apparatus of claim 1 or 2, wherein the at least one connection component includes an array of connectors and a socket, wherein:
the array of connectors is disposed on a portion of a bottom surface of the substrate that is associated with an opening of the stiffener, and
the socket is disposed on a top surface of the PCB.

4. The apparatus of claim 1, 2 or 3, wherein the at least one connection component includes a ball grid array (BGA), wherein:
the top surface of the PCB includes a pedestal portion, and
the BGA is disposed on the pedestal portion of the top surface of the PCB and on a portion of a bottom surface of the substrate that is associated with an opening of the stiffener;
and for example wherein the top surface of the PCB includes a cavity that defines the pedestal portion of the top surface of the PCB.

5. The apparatus of any preceding claim, wherein:
the semiconductor package is disposed on a top surface of the PCB,
wherein a top surface of the stiffener is disposed on a bottom surface of the substrate, and
wherein a bottom surface of the stiffener is disposed on the top surface of the PCB; and
the at least one connection component is configured to connect the PCB and the semiconductor package.

6. The apparatus of claim 5, wherein the at least one connection component includes another PCB, wherein:
a bottom surface of the other PCB is disposed on the top surface of the PCB, and
a top surface of the other PCB is disposed on a bottom surface of the substrate.

7. The apparatus of claim 6, wherein:
the bottom surface of the other PCB is connected to the top surface of the PCB via a first ball grid array (BGA), and
the top surface of the other PCB is connected to the bottom surface of the substrate via a second BGA.

8. The apparatus of claim 6 or 7, wherein the stiffener has a top surface, a bottom surface, and an opening extending through the top surface and the bottom surface of the stiffener, and wherein:
the other PCB is disposed within the opening of the stiffener, and
the top surface of the other PCB is disposed on a portion of a bottom surface of the substrate that is associated with the opening of the stiffener.

9. The apparatus of any of claims 5 to 8, wherein the at least one connection component includes an array of connectors and a socket that are configured to connect to each other, wherein:
the array of connectors is disposed on a bottom surface of the substrate, and
the socket is disposed on the top surface of the PCB.

10. The apparatus of claim 9, wherein the stiffener has a top surface, a bottom surface, and an opening extending through the top surface and the bottom surface of the stiffener, and wherein:
the array of connectors is disposed within the opening of the stiffener, and
the array of connectors is disposed on a portion of a bottom surface of the substrate that is associated with the opening of the stiffener.

11. The apparatus of claim 9 or 10, wherein:
the array of connectors includes one or more selected from the group comprising: land grid array (LGA) connectors, and the socket includes an LGA socket; and pin grid array (PGA) connectors, and the socket includes a PGA socket.

12. The apparatus of any of claims 5 to 11, wherein the at least one connection component includes a ball grid array (BGA), wherein:
the top surface of the PCB includes a pedestal portion, and
the BGA is disposed on the pedestal portion and on the bottom surface of the substrate.

13. The apparatus of claim 12, wherein the stiffener has a top surface, a bottom surface, and an opening extending through the top surface and the bottom surface of the stiffener, and wherein:
the pedestal portion of the top surface of the PCB is disposed within the opening of the stiffener, and
the BGA is disposed on a portion of a bottom surface of the substrate that is associated with the opening of the stiffener;
and for example wherein the top surface of the PCB includes a cavity that surrounds the pedestal portion, and wherein the stiffener is disposed within the cavity.

14. An apparatus, comprising:
a substrate;
a stiffener with an opening disposed on a bottom surface of the substrate;
a printed circuit board (PCB) disposed on a bottom surface of the stiffener; and
at least one connection component that is configured to connect the PCB to at least one of the stiffener or the substrate.

15. The apparatus of claim 14, wherein the at least one connection component includes one or more selected from the group comprising:
another PCB, wherein, the other PCB is disposed within the opening of the stiffener, a top surface of the other PCB is disposed on a portion of the bottom surface of the substrate that is associated with the opening of the stiffener, and a bottom surface of the other PCB is disposed on the top surface of the PCB;
an array of connectors and a socket, wherein, the array of connectors is disposed within the opening of the stiffener, the array of connectors is disposed on a portion of the bottom surface of the substrate that is associated with the opening of the stiffener, and the socket is disposed on a top surface of the PCB; and
a ball grid array (BGA), wherein, a top surface of the PCB includes a pedestal portion, the pedestal portion of the top surface of the PCB is disposed within the opening of the stiffener, and the BGA is disposed on the pedestal portion of the top surface of the PCB and on a portion of a bottom surface of the substrate that is associated with the opening of the stiffener.
